# EUROPEAN PATENT SPECIFICATION

(11) **EP 2 902 846 B1**
(45) Date of publication and mention of the grant of the patent: **20.11.2019**
(21) Application number: 12884755.5
(22) Date of filing: 24.09.2012
(51) Int. Cl.: G03F 7/022, G03F 7/023, G03F 7/039

(54) **POSITIVE PHOTOSENSITIVE RESIN COMPOSITION**
POSITIVE LICHTEMPFINDLICHE HARZZUSAMMENSETZUNG
COMPOSITION DE RÉSINE PHOTOSENSIBLE POSITIVE

(43) Date of publication of application: 05.08.2015
(73) Proprietor: Toray Industries, Inc., Tokyo 103-8666 (JP)
(72) Inventor: MASUDA, Yuki, Shiga 520-8558 (JP); KAMEMOTO, Satoshi, Shiga 520-8558 (JP); ONISHI, Hiroyuki, Otsu-shi, Shiga 520-8558 (JP); TOMIKAWA, Masao, Shiga 520-8558 (JP)
(74) Representative: Hoefer & Partner Patentanwälte mbB
(86) International application number: PCT/JP2012/074367
(87) International publication number: WO 2014/045434

(56) References cited:
- EP-A2- 2 333 015
- WO-A1-2010/047271
- WO-A1-2012/002134
- JP-A- 2009 221 453
- JP-A- 2009 244 628
- JP-A- 2010 085 673
- JP-A- 2010 209 265
- JP-A- 2011 017 898
- JP-A- 2011 116 968
- JP-A- 2012 181 488

## Description

### [Technical Field]

The present invention relates to a positive-type photosensitive resin composition. More particularly, the present invention relates to a positive-type photosensitive resin composition which is suitably used in a surface protective film and an interlayer dielectric film of semiconductor devices, an insulating layer of organic electroluminescence elements, and the like.

### [Background Art]

Heretofore, polyimide-based and polybenzoxazole-based resins having excellent heat resistance and mechanical properties have widely been used in a surface protective film, an interlayer dielectric film, and the like of semiconductor devices of electronic devices. In the case of forming a thin film made of these resins, when a coating film of a polyimide precursor or a polybenzoxazole precursor is thermally cyclodehydrated to obtain a thin film having excellent heat resistance and mechanical properties, a heating treatment at a high temperature of about 350°C is usually needed.

However, due to requirements such as reduction of thermal load and achievement of low warpage for devices, there has recently been required a polyimide-based or polybenzoxazole-based resin which is curable by a heating treatment at a low temperature of about 250°C or lower, and more preferably 200°C or lower.

There have been known, as a low-temperature curable resin composition, a photosensitive resin in which a ring-closed polyimide, a photo acid generator, and a heat crosslinking agent having a methylol group are used (Patent Literature 1), a photosensitive resin composition in which a polybenzoxazole precursor including an aliphatic introduced therein and a photo acid generator are used (Patent Literature 2), a resin composition containing a cyclic olefin resin, a photo acid generator, and an epoxy resin (Patent Literature 3), resin compositions containing a ring-closed soluble polyimide and an unsaturated polymerization compound, a compound having an epoxy group, and a photopolymerization (Patent Literatures 4 and 5), and the like.

### [Citation List]

### [Patent Literature]

[Patent Literature 1]
   Japanese Unexamined Patent Publication (Kokai) No. 2006-313237
[Patent Literature 2]
   Japanese Unexamined Patent Publication (Kokai) No. 2008-224984
[Patent Literature 3]
   Japanese Unexamined Patent Publication (Kokai) No. 2007-78781
[Patent Literature 4]
   Japanese Unexamined Patent Publication (Kokai) No. 2009-258471
[Patent Literature 5]
   Japanese Unexamined Patent Publication (Kokai) No. 2011-17198

JP 2009 244628 A, EP 2 333 015 A2 and JP 2010 209265 A represent the prior art closest to the invention. These documents disclose positive photosensitive compositions which merely differ from the composition of the present invention in that the contained alkali-soluble polyimide does not include a diamine residue with an polyalkylene oxide group and/or a carboxylic acid residue with an polyalkylene oxide group.

### [Summary of Invention]

### [Technical Problem]

However, the resin composition of Patent Literature 1 had a problem such as large warpage because of high elastic modulus and high shrinkability during curing. The photosensitive resin composition of Patent Literature 2 could achieve low elastic modulus, but film shrinkage due to dehydration ring closure leads to large warpage. The resin composition of Patent Literature 3 enabled curing at a low temperature and achievement of low warpage, but had a problem such as poor resolution. The resin compositions of Patent Literatures 4 and 5 are materials which have excellent mechanical properties and exhibit low warpage, but had a problem such as poor resolution since they are negative-type compositions in which the exposed area is left as a residual film.

An object of the present invention is to provide a positive-type photosensitive resin composition capable of obtaining a high-resolution cured film which exhibits low warpage and also does not cause pattern embedment by reflow during a heating treatment at a low temperature of 200°C or lower.

### [Solution to Problem]

In order to achieve the above object, the positive-type photosensitive resin composition of the present invention consists of the following constituents. Namely, the positive-type photosensitive resin composition includes (a) an alkali-soluble polyimide, (b) a compound having two or more epoxy groups in a molecule, and (c) a photo acid generator, in which the content of the compound having two or more epoxy groups in a molecule (b) is within a range of 5 to 50 parts by weight based on 100 parts by weight of the alkali-soluble polyimide (a), and in which the alkali-soluble polyimide (a) includes a diamine residue having a polyalkylene oxide group and/or a carboxylic acid residue having a polyalkylene oxide group.

### [Advantageous Effects of Invention]

The present invention can provide a positive-type photosensitive resin composition capable of obtaining a high-resolution cured film which exhibits low warpage and also does not cause pattern embedment by reflow during a heating treatment at a low temperature of 200°C or lower.

### [Description of Embodiments]

The alkali-soluble polyimide (a) (hereinafter also referred to as a component (a)) used in the present invention can be obtained by reacting a component selected from tetracarboxylic acid, tetracarboxylic dianhydride, and tetracarboxylic acid diester dichloride with a component selected from diamine, a diisocyanate compound, and a trimethylsilylated diamine to obtain a polyamic acid, and allowing the polyamic acid to undergo dehydration ring closure by a heating treatment, or a chemical treatment with an acid or a base. The component (a) may not be partially ring-closed as long as a ring closure ratio is 85% or more. The ring closure ratio can be determined by applying the component (a) on a silicon wafer, making a comparison between peak intensities at about 1,377 cm⁻¹ before and after curing by an infrared absorption spectrum, and calculating an imidation ratio. Two or monomer components (a) may be contained.

Here, the alkali-soluble polyimide is a polyimide which is dissolved in an aqueous alkali solution to be used as the below-mentioned developing solution. When such a component (a) is contained, the positive-type photosensitive resin composition of the present invention can be developed with the aqueous alkali solution.

The alkali-soluble polyimide (a) has a polyalkylene oxide group. Examples of the polyalkylene oxide group include a polyethylene oxide group, a polypropylene oxide group, a polybutylene oxide group, and the like. Of these polyalkylene oxide groups, a polyethylene oxide group is most preferable. The polyethylene oxide group means a polyethylene oxide group represented by the following general formula (1) in which "a" is an integer of 2 or more. "a" is preferably within a range of 2 to 15.

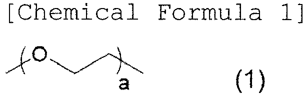

The alkali-soluble polyimide (a) includes a diamine residue and an acid anhydride residue. In order that the component (a) has a polyalkylene oxide group, the component may include a diamine residue having a polyalkylene oxide group, or an acid anhydride residue having a polyalkylene oxide group . The proportion of total residues of the diamine residue having a polyalkylene oxide group and the carboxylic acid residue having a polyalkylene oxide group is preferably within a range of 5 to 20 mol% based on 100% of the total of all diamine residues and all carboxylic acid residues included in the alkali-soluble polyimide (a). The proportion of total residues of the diamine residue having a polyethylene oxide group and the carboxylic acid residue having a polyethylene oxide group is within a range of 5 to 20 mol% based on 100% of the total of all diamine residues and all carboxylic acid residues included in the alkali-soluble polyimide (a). Thus, it is possible to obtain a cured film which exhibits low warpage and also has high heat resistance.

Examples of the diamine having a polyethylene oxide group include, but are not limited to, JEFFAMINE (registered trademark) KH-511, JEFFAMINE (registered trademark) ED-600, JEFFAMINE (registered trademark) ED-900, JEFFAMINE (registered trademark) ED-2003, JEFFAMINE (registered trademark) EDR-148, JEFFAMINE (registered trademark) EDR-176 (which are trade names, manufactured by Huntsman Corporation), and the like. Chemical structures of these diamines are shown below.

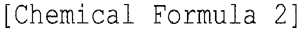

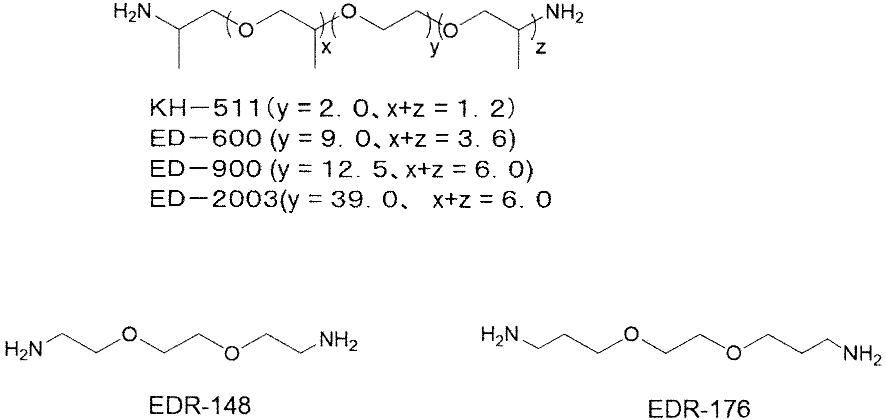

In the above formulas, x, y, and z are averages.

The alkali-soluble polyimide (a) may include a diamine residue having no polyethylene oxide group. Examples of the diamine residue include residues of, for example, polyoxypropylenediamines D-200, D-400, D-2000, and D-4000 (which are trade names, manufactured by Huntsman Corporation) ; hydroxyl group-containing diamines such as bis(3-amino-4-hydroxyphenyl)hexafluoropropane, bis(3-amino-4-hydroxyphenyl) sulfone, bis(3-amino-4-hydroxyphenyl)propane, bis(3-amino-4-hydroxyphenyl)methylene, bis(3-amino-4-hydroxyphenyl)ether, bis(3-amino-4-hydroxy)biphenyl, and bis(3-amino-4-hydroxyphenyl)fluorene; sulfonic acid-containing diamines such as 3-sulfonic acid-4,4'-diaminodiphenylether; thiol group-containing diamines such as dimercaptophenylenediamine; aromatic diamines such as 3,4'-diaminodiphenylether, 4,4'-diaminodiphenylether, 3,4'-diaminodiphenylmethane, 4,4'-diaminodiphenylmethane, 3,4'-diaminodiphenylsulfone, 4,4'-diaminodiphenylsulfone, 3,4'-diaminodiphenyl sulfide, 4,4'-diaminodiphenyl sulfide, 1,4-bis(4-aminophenoxy)benzene, benzine, m-phenylenediamine, p-phenylenediamine, 1,5-naphthalenediamine, 2,6-naphthalenediamine, bis(4-aminophenoxyphenyl)sulfone, bis(3-aminophenoxyphenyl)sulfone, bis(4-aminophenoxy)biphenyl, bis{4-(4-aminophenoxy)phenyl}ether, 1,4-bis(4-aminophenoxy)benzene, 2,2'-dimethyl-4,4'-diaminobiphenyl, 2,2'-diethyl-4,4'-diaminobiphenyl, 3,3'-dimethyl-4,4'-diaminobiphenyl, 3,3'-diethyl-4,4'-diaminobiphenyl, 2,2',3,3'-tetramethyl-4,4'-diaminobiphenyl, 3,3',4,4'-tetramethyl-4,4'-diaminobiphenyl, and 2,2'-bis(trifluoromethyl)-4,4'-diaminobiphenyl; compounds in which hydrogen atoms of the aromatic ring of these aromatic diamines are partially substituted with an alkyl group having 1 to 10 carbon atoms, a fluoroalkyl group, a halogen atom, and the like; and alicyclic diamines such as cyclohexyldiamine and methylenebiscyclohexylamine. These diamines can be used as they are, or used as corresponding diisocyanate compounds or trimethylsilylated diamines. Two or more diamine components may be used in combination. In applications which require heat resistance, the aromatic diamine to be used preferably accounts for 50 mol% or more of the whole diamine.

The component (a) is capable of having a phenolic hydroxyl group, a sulfonic acid group, a thiol group, and the like. When using the component (a) moderately having a phenolic hydroxyl group, a sulfonic acid group, and a thiol group, a positive-type photosensitive resin composition having moderate alkali-solubility is obtained. Particularly, the phenolic hydroxyl group is more preferable because of having high reactivity with an epoxy group and a thermally crosslinkable compound.

As long as heat resistance does not deteriorate, it is possible to copolymerize with the diamine or acid anhydride residue having an aliphatic group with a siloxane structure, thus enabling an improvement in adhesion to a substrate. Specific examples thereof include those obtained by copolymerizing with 1 to 15 mol% of bis(3-aminopropyl)tetramethyldisiloxane, bis(p-aminophenyl)octamethylpentasiloxane, and the like as the diamine component.

Examples of the acid anhydride constituting the acid anhydride residue of the alkali-soluble polyimide (a) include pyromellitic dianhydride, 2,2'-hexafluoropropylidenediphthalic dianhydride, 4,4'-oxydiphthalic anhydride, 3,3',4,4'-benzophenonetetracarboxylic dianhydride, 1,2,5,6-naphthalenetetracarboxylic dianhydride, 2,3,6,7-naphthalenetetracarboxylic anhydride, 1,4,5,8-naphthalenetetracarboxylic dianhydride, 1,1-bis(2,3-dicarboxylphenyl)ethane dianhydride, 2,2-bis(2,3-dicarboxylphenyl)ethane dianhydride, 2,2-bis(3,3-carboxylphenyl)ethane dianhydride, 2,2-bis[4-(3,4-dicarboxyphenoxy)phenyl]propane dianhydride, 3,3',4,4'-biphenylethertetracarboxylic dianhydride, 2,3,3',4'-biphenylethertetracarboxylic dianhydride, 2,3,5,6-pyridinetetracarboxylic dianhydride, pyromellitic dianhydride, 3,4,9,10-perylenetetracarboxylic dianhydride, 2,3,3',4'-benzophenonetetracarboxylic dianhydride, 3,3',4,4'-benzophenonetetracarboxylicdianhydride, and the like. Examples of acid anhydride having a polyethylene oxide group include, but are not limited to, an acid anhydride obtained by reacting trimellitic anhydride chloride with the above-mentioned diamine having a polyethylene oxide group at 0°C or lower. Two or more of these acid anhydrides may be used.

In order to improve storage stability of the positive-type photosensitive resin composition, the main chain terminal of the component (a) is preferably blocked with a terminal blocking agent such as a monoamine, an acid anhydride, a monocarboxylic acid, a mono acid chloride compound, or a monoactive ester compound. When monoamine is used as the terminal blocking agent, the introduction proportion of the monoamine is preferably 0.1 mol% or more, particularly preferably 5 mol% or more, preferably 60 mol% or less, and particularly preferably 50 mol% or less, based on the whole amine component. When the acid anhydride, monocarboxylic acid, mono acid chloride compound, or monoactive ester compound is used as the terminal blocking agent, the introduction proportion is preferably 0.1mol ormore, particularly preferably 5 mol or more, preferably 100 mol or less, and particularly preferably 90 mol or less, based on 100 mol of the diamine component. Plural different terminal groups may be introduced by reacting plural terminal blocking agents.

The monoamine is preferably M-600, M-1000, M-2005, M-2070 (which are trade names, manufactured by Huntsman Corporation), aniline, 2-ethynylaniline, 3-ethynylaniline, 4-ethynylaniline, 5-amino-8-hydroxyquinoline, 1-hydroxy-7-aminonaphthalene, 1-hydroxy-6-aminonaphthalene, 1-hydroxy-5-aminonaphthalene, 1-hydroxy-4-aminonaphthalene, 2-hydroxy-7-aminonaphthalene, 2-hydroxy-6-aminonaphthalene, 2-hydroxy-5-aminonaphthalene, 1-carboxy-7-aminonaphthalene, 1-carboxy-6-aminonaphthalene, 1-carboxy-5-aminonaphthalene, 2-carboxy-7-aminonaphthalene, 2-carboxy-6-aminonaphthalene, 2-carboxy-5-aminonaphthalene, 2-aminobenzoic acid, 3-aminobenzoic acid, 4-aminobenzoic acid, 4-aminosalicylic acid, 5-aminosalicylic acid, 6-aminosalicylic acid, 2-aminobenzenesulfonic acid, 3-aminobenzenesulfonic acid, 4-aminobenzenesulfonic acid, 3-amino-4,6-dihydroxypyrimidine, 2-aminophenol, 3-aminophenol, 4-aminophenol, 2-aminothiophenol, 3-aminothiophenol, 4-aminothiopheno, and the like. Two or more of these monoamines maybe used. Of these monoamines, M-600, M-1000, M-2005, and M-2070 are preferable in that they are excellent in low warpage because of having a polyethylene oxide group.

The acid anhydride, monocarboxylic acid, mono acid chloride compound, and monoactive ester compound are preferably acid anhydrides such as phthalic anhydride, maleic anhydride, nadic anhydride, cyclohexanedicarboxylic anhydride, and 3-hydroxyphthalic anhydride; monocarboxylic acids such as 3-carboxyphenol, 4-carboxyphenol, 3-carboxythiophenol, 4-carboxythiophenol, 1-hydroxy-7-carboxynaphthalene, 1-hydroxy-6-carboxynaphthalene, 1-hydroxy-5-carboxynaphthalene, 1-mercapto-7-carboxynaphthalene, 1-mercapto-6-carboxynaphthalene, 1-mercapto-5-carboxynaphthalene, 3-carboxybenzenesulfonic acid, and 4-carboxybenzenesulfonic acid, and mono acid chloride compounds in which carboxyl groups thereof are converted into acid chlorides; mono acid chloride compounds in which only one carboxyl group of dicarboxylic acids such as terephthalic acid, phthalic acid, maleic acid, cyclohexanedicarboxylic acid, 1,5-dicarboxynaphthalene, 1,6-dicarboxynaphthalene, 1,7-dicarboxynaphthalene, and 2,6-dicarboxynaphthalene acid is converted into acid chlorides; and active ester compounds obtained by reacting a mono acid chloride compound with N-hydroxybenzotriazole or N-hydroxy-5-norbornene-2,3-dicarboxyimide. Two or more of these compounds may be used.

The terminal blocking agent introduced into the component (a) can be easily detected by the following method. The terminal blocking agent can be easily detected, for example, by dissolving the component (a) including the terminal blocking agent introduced therein in an acidic solution, decomposing the solution into an amine component and an acid anhydride component as structural units, and measuring the components using gas chromatography (GC) or NMR. Alternatively, it is possible to easily detect the terminal blocking agent by directly measuring the component (a) including the terminal blocking agent introduced therein using a pyrolysis gas chromatograph (PGC), an infrared spectrum, and a ¹³C-NMR spectrum.

The alkali-soluble polyimide (a) preferably has a weight average molecular weight of 10,000 or more and 30,000 or less. Here, the weight average molecular weight is a value determined in terms of polystyrene using gel permeation chromatography (GPC). It is possible to improve folding resistance of the film after curing by adjusting the weight average molecular weight to 10,000 or more. Meanwhile, it is possible to improve developability with an aqueous alkali solution by adjusting the weight average molecular weight to 30,000 or less. In order to obtain a cured film having excellent mechanical properties, the weight average molecular weight is more preferably 20,000 or more. When containing two or more of alkali-soluble polyimides, the weight average molecular weight of at least one alkali-soluble polyimide may be within the above range.

The positive-type photosensitive resin composition of the present invention contains a compound having two or more epoxy groups in a molecule (b) (hereinafter also referred to as the component (b)). The epoxy group is thermally crosslinked with a polymer at 200°C or lower and also does not cause a dehydration reaction due to crosslinking, and thus film shrinkage is less likely to occur. Therefore, inclusion of the component (b) is effective for curing at a low temperature of the resin composition, and achievement of low warpage.

Since the component (b) has two or more epoxy groups, it becomes possible to increase the molecular weight due to thermal crosslinking of the alkali-soluble polyimide (a) with the component (b), and thus a cured film having excellent mechanical properties can be obtained.

The compound having two or more epoxy groups in a molecule (b) preferably has a polyethylene oxide group. Thus, itispossible to more decrease the elastic modulus and to achieve low warpage. Because of high flexibility, it is possible to obtain a cured film which is also excellent in elongation. The polyethylene oxide group means those of the general formula (1) in which "a" is an integer of 2 or more, and preferably within a range of 2 to 15.

Examples of the compound having two or more epoxy groups in a molecule (b) include, but are not limited to, a bisphenol A type epoxy resin; a bisphenol F type epoxy resin; an alkylene glycol type epoxy resin such as propylene glycol diglycidyl ether; a polyalkylene glycol type epoxy resin such as polypropylene glycol diglycidyl ether; and an epoxy group-containing silicone such as polymethyl(glycidyloxypropyl)siloxane. Specific examples thereof include EPICLON (registered trademark) 850-S, EPICLON (registered trademark) HP-4032, EPICLON (registered trademark) HP-7200, EPICLON (registered trademark) HP-820, EPICLON (registered trademark) HP-4700, EPICLON (registered trademark) EXA-4710, EPICLON (registered trademark) HP-4770, EPICLON (registered trademark) EXA-859CRP, EPICLON (registered trademark) EXA-1514, EPICLON (registered trademark) EXA-4880, EPICLON (registered trademark) EXA-4850-150, EPICLON EXA-4850-1000, EPICLON (registered trademark) EXA-4816, EPICLON (registered trademark) EXA-4822 (which are trade names, manufactured by Dainippon Ink and Chemicals, Inc.), RIKARESIN (registered trademark) BEO-60E (which is trade name, manufactured by New Japan Chemical Co., Ltd.), EP-4003S, EP-4000S (ADEKA CORPORATION), and the like. Of these, an epoxy resin having a polyethylene oxide group is preferable because of being excellent in low warpage and heat resistance. For example, EPICLON (registered trademark) EXA-4880, EPICLON (registered trademark) EXA-4822, and RIKARESIN (registered trademark) BEO-60E are preferable because of having a polyethylene oxide group.

The content of the component (b) is within a range of 5 to 50 parts by weight, preferably 10 to 50 parts by weight, and more preferably 10 to 40 parts by weight, based on 100 parts by weight of the alkali-soluble polyimide (a). The amount of less than 10 parts by weight fails to achieve low warpage of a cured film of a positive-type photosensitive resin composition, while the content of more than 50 parts by weight leads to the occurrence of pattern embedment by reflow during curing to cause drastic deterioration of resolution.

The positive-type photosensitive resin composition of the present invention contains (c) a photo acid generator. Inclusion of the photo acid generator (c) leads to the generation of an acid the UV exposed area to cause an increase in solubility of the exposed area in an aqueous alkali solution, thus making it possible to use as a positive-type photosensitive resin composition.

Examples of the photo acid generator (c) include a quinonediazide compound, a sulfonium salt, a phosphonium salt, a diazonium salt, an iodonium salt, and the like. Of these photo acid generators, the quinonediazide compound is preferably used in view of the fact that excellent dissolution suppressing effect is exerted and a positive-type photosensitive resin composition having high sensitivity and low thickness loss is obtained. Two or more of photo acid generators (c) may be included. Thus, a ratio of a dissolution rate of the exposed area to that of the unexposed area can be increased, and thus high-sensitivity positive-type photosensitive resin composition can be obtained.

The quinonediazide compound include those with sulfonic acid of quinonediazide ester-bonded to a polyhydroxy compound, those with sulfonic acid of quinonediazide sulfoneamide-bonded to a polyamino compound, and those with sulfonic acid of quinonediazide ester-bonded and/or sulfoneamide-bonded to a polyhydroxypolyamino compound. All functional groups of these polyhydroxy compounds and polyamino compounds may not be substituted with quinonediazide, but 50 mol % or more of all functional groups is preferably substituted with quinonediazide. By using such a quinonediazide compound, a positive-type photosensitive resin composition which is photosensitive to i-line (wavelength 365 nm), h-line (wavelength 405 nm), and g-line (wavelength 436 nm) of a mercury lamp, which are common ultraviolet rays, can be obtained.

Both a compound having a 5-naphthoquinonediazidesulfonyl group and a compound having a 4-naphthoquinonediazidesulfonyl group can be preferably used as quinonediazide compound. A compound having both of these groups in the same molecule may be used, or compounds each having a different group may be used in combination.

Examples of the method for producing a quinonediazide compound include a method in which 5-naphthoquinone diazide sulfonyl chloride is reacted with a phenol compound in the presence of triethylamine . Examples of the method for synthesizing a phenol compound include a method in which an α-(hydroxyphenyl)styrene derivative is reacted with a polyhydric phenol compound in the presence of an acid catalyst.

The content of the photo acid generator (c) is preferably within a range of 3 to 40 parts by weight based on 100 parts by weight of the resin as the component (a). An attempt can be made to achieve higher sensitivity by adjusting the content of the photo acid generator (c) within the above range. Furthermore, a sensitizer may be further contained.

The positive-type photosensitive resin composition of the present invention preferably contains, in addition to the component (b), (d) a thermally crosslinkable compound. Specifically, the thermally crosslinkable compound (d) is preferably a compound having at least two alkoxymethyl or methylol groups. Here, examples of the alkoxymethyl group include a methoxymethyl group, an ethoxymethyl group, a propoxymethyl group, abutoxymethyl group, and the like. Inclusion of at least two of these groups enables a condensation reaction between the resin and the same kinds of molecules to give a crosslinked structure. Use of the thermally crosslinkable compound (d) in combination with the component (b) enables various wide-ranging designs for improving sensitivity of the positive-type photosensitive resin composition and mechanical properties of the cured film.

Preferred examples of such a compound include a methyloled melamine compound, a methoxymethylated melamine compound, a compound having a dimethylolphenyl group, a compound having a dimethoxymethylphenyl group, and the like. By containing these compounds, pattern embedment by reflow during curing becomes less likely to occur, thus enabling an improvement in resolution.

Specific examples of such a compound include DML-PC, DML-PEP, DML-OC, DML-OEP, DML-34X, DML-PTBP, DML-PCHP, DML-OCHP, DML-PFP, DML-PSBP, DML-POP, DML-MBOC, DML-MBPC, DML-MTrisPC, DML-BisOC-Z, DML-BisOCHP-Z, DML-BPC, DML-BisOC-P, DMOM-PC, DMOM-PTBP, DMOM-MBPC, TriML-P, TriML-35XL, TML-HQ, TML-BP, TML-pp-BPF, TML-BPE, TML-BPA, TML-BPAF, TML-BPAP, TMOM-BP, TMOM-BPE, TMOM-BPA, TMOM-BPAF, TMOM-BPAP, HML-TPPHBA, HML-TPHAP, HMOM-TPPHBA, HMOM-TPHAP (which are trade names, manufactured by Honshu Chemical Industry Co., Ltd.), NIKALAC (registered trademark) MX-290, NIKALAC (registered trademark) MX-280, NIKALAC (registered trademark) MX-270, NIKALAC (registered trademark) MX-279, NIKALAC (registered trademark) MW-100LM, NIKALAC (registered trademark) MX-750LM (which are trade names, manufactured by Sanwa Chemical Co., Ltd.), and the like. Two or more of these compounds may be contained.

The content of the thermally crosslinkable compound (d) is preferably adjusted to 10 parts by weight or less based on 100 parts by weight of the component (a). When the content is within the above range, various wide-ranging designs can be more appropriately performed so as to improve sensitivity and mechanical properties of the cured film.

Furthermore, a weight ratio of the compound having two or more epoxy groups in a molecule (b) to the thermally crosslinkable compound (d) is preferably within a range of 15:1 to 1:1. When the weight ratio is within the above range, it is possible to obtain a high-resolution cured film which causes neither low warpage nor pattern embedment by reflow.

The low molecular weight compound having a phenolic hydroxyl group may be optionally contained as long as a shrinkage residual film rate after curing does not decrease. Thus, the developing time can be reduced.

Examples of such a compound include Bis-Z, BisP-EZ, TekP-4HBPA, TrisP-HAP, TrisP-PA, BisOCHP-Z, BisP-MZ, BisP-PZ, BisP-IPZ, BisOCP-IPZ, BisP-CP, BisRS-2P, BisRS-3P, BisP-OCHP, methylenetris-FR-CR, BisRS-26X (which are trade names, manufactured byHonshu Chemical Industry Co., Ltd.), BIP-PC, BIR-PC, BIR-PTBP, BIR-BIPC-F (which are trade names, manufactured by ASAHI ORGANIC CHEMICALS INDUSTRY CO., LTD.), and the like. Two or more of these compounds may be contained.

The content of the low molecular weight compound having a phenolic hydroxyl group is preferably within a range of 1 to 40 parts by weight based on 100 parts by weight of the component (a).

The positive-type photosensitive resin composition of the present invention preferably contains a solvent. Examples of the solvent include polar aprotic solvents such as N-methyl-2-pyrrolidone, γ-butyrolactone, N,N-dimethylformamide, N,N-dimethylacetamide, and dimethyl sulfoxide; ethers such as tetrahydrofuran, dioxane, propylene glycol monomethyl ether, and propylene glycol monoethyl ether; ketones such as acetone, methyl ethyl ketone, and diisobutyl ketone; esters such as ethyl acetate, butyl acetate, isobutyl acetate, propyl acetate, propylene glycol monomethyl ether acetate, and 3-methyl-3-methoxybutyl acetate; alcohols such as ethyl lactate, methyl lactate, diacetone alcohol, and 3-methyl-3-methoxybutanol; and aromatic hydrocarbons such as toluene and xylene . Two or more of these solvents may be contained. The content of the solvent is preferably within a range of 100 to 1,500 parts by weight based on 100 parts by weight of the component (a).

The positive-type photosensitive resin composition of the present invention may optionally contain surfactants; esters such as ethyl lactate and propylene glycol monomethyl ether acetate; alcohols such as ethanol; ketones such as cyclohexanone and methyl isobutyl ketone; and ethers such as tetrahydrofuran and dioxane, for the purpose of improving wettability with a substrate.

The positive-type photosensitive resin composition of the present invention may contain inorganic particles. Preferred specific examples include, but are not limited to, silicon oxide, titanium oxide, barium titanate, alumina, talc, and the like. These inorganic particles preferably have a primary particle diameter of 100 nm or less, and more preferably 60 nm or less.

In order to enhance adhesion to the substrate, the positive-type photosensitive resin composition of the present invention may contain, as a silicone component, silane coupling agents such as trimethoxyaminopropylsilane, trimethoxyepoxysilane, trimethoxyvinylsilane, and trimethoxythiolpropylsilane, as long as storage stability does not deteriorate. The content of the silane coupling agent is preferably within a range of 0.01 to 5 parts by weight based on 100 parts by weight of the component (a).

The positive-type photosensitive resin composition of the present invention may contain alkali-soluble resins excluding the component (a). Specific examples thereof include an alkali-soluble polybenzoxazole, an acrylic polymer obtained by copolymerizing acrylic acid, a novolak resin, a siloxane resin, and the like. Such a resin is dissolved in an aqueous alkali solution to be used as the below-mentioned developing solution. Inclusion of these alkali-soluble resins enables imparting of properties of each alkali-soluble resin while maintaining adhesion of a cured film and excellent sensitivity.

The positive-type photosensitive resin composition of the present invention preferably has a viscosity within a range of 2 to 5,000 mPa·s. It becomes easy to obtain a desired film thickness by adjusting the solid content so that the viscosity becomes 2 mPa·s or more. Meanwhile, when the viscosity is 5,000 mPa·s or less, it becomes easy to obtain a coating film having high uniformity. The positive-type photosensitive resin composition having such a viscosity can be easily obtained, for example, by adjusting the solid content within a range of 5 to 60% by weight.

A description will be made of a method for forming a heat-resistant resin pattern using the positive-type photosensitive resin composition of the present invention.

The positive-type photosensitive resin composition of the present invention is applied on a substrate. Examples of the substrate to be used include, but are not limited to, a silicon wafer, ceramics, gallium arsenide, and the like. The coating method includes a spin coating method using a spinner, a spray coating method, a roll coating method, and the like. Although the thickness of a coating film varies depending on the coating technique, the viscosity and solid content of the composition, and the like, the composition is usually applied so that the film thickness after drying becomes 0.1 to 150 µm.

It is also possible to subject the above-mentioned substrate to a pretreatment with a silane coupling agent before applying the positive-type photosensitive resin composition so as to enhance adhesion between the substrate such as a silicon wafer and the positive-type photosensitive resin composition. For example, using a solution prepared by dissolving a silane coupling agent in a solvent such as isopropanol, ethanol, methanol, water, tetrahydrofuran, propylene glycol monomethyl ether acetate, propylene glycol monomethyl ether, ethyl lactate, or diethyl adipate in the concentration of 0.5 to 20% by weight, the substrate is subjected to a surface treatment by a method such as a spin coating, dipping, spray coating, or steam treatment method. In some cases, a reaction between the substrate and the silane coupling agent is allowed to proceed by performing a heat treatment at a temperature ranging from 50°C to 300°C.

Next, the substrate coated with the positive-type photosensitive resin composition is dried to obtain a positive-type photosensitive resin composition coating film. Drying is preferably performed at a temperature within a range of 50°C to 150°C for one minute to several hours, using an oven, a hot plate, infrared rays, and the like.

Next, this positive-type photosensitive resin composition coating film is exposed by irradiation with actinic rays through a mask having a desired pattern. Examples of actinic rays used for exposure include ultraviolet rays, visible rays, electronbeams, X-rays. In the present invention, actinic rays selected from i-line (wavelength of 365 nm), h-line (wavelength of 405 nm), and g-line (wavelength of 436 nm) from a mercury lamp are preferably used.

In order to form a pattern of a heat-resistant resin, the exposed area is removed after exposure, using a developing solution. The developing solution is preferably an aqueous alkali solution. An aqueous alkali solution is preferably an aqueous solution of compounds exhibiting alkalinity, such as tetramethylammonium hydroxide, diethanolamine,diethylaminoethanol, sodiumhydroxide, potassium hydroxide, sodium carbonate, potassium carbonate, triethylamine, diethylamine, methylamine, dimethylamine, dimethylaminoethyl acetate, dimethylaminoethanol, dimethylaminoethyl methacrylate, cyclohexylamine, ethylenediamine, and hexamethylenediamine. In some cases, to these aqueous alkali solutions, polar solvents such as N-methyl-2-pyrrolidone, N,N-dimethylformamide, N,N-dimethylacetamide, dimethyl sulfoxide, γ-butyrolactone, and dimethylacrylamide; alcohols such as methanol, ethanol, and isopropanol; esters such as ethyl lactate and propylene glycol monomethyl ether acetate; and ketones such as cyclopentanone, cyclohexanone, isobutyl ketone, and methyl isobutyl ketone may be added alone or in combination of several kinds thereof. After the development, a rinsing treatment is preferably performed using water. Here, the rinsing treatment may be performed using alcohols such as ethanol and isopropyl alcohol, esters such as ethyl lactate and propylene glycol monomethyl ether acetate, and the like added to water.

After the development, a thermal crossliking reaction of the resin coating film is allowed to proceed by heating at a temperature of 100 to 200°C, thus improving heat resistance and chemical resistance. This heating treatment is carried out for 5 minutes to 5 hours such that the temperature is selected and the temperature is elevated stepwise, or a certain temperature range is selected and the temperature is continuously elevated. As one example, a heat treatment is performed at 130°C and 200°C for 30 minutes, respectively. Curing is preferably performed under the condition of the temperature of 150°C or higher and 250°C or lower. Since the present invention provides a cured film having particularly excellent curability at a low temperature, the condition of the temperature of 150°C or higher and 200°C or lower is more preferable.

The cured film formed from the positive-type photosensitive resin composition of the present invention is suitably used for applications such as passivation films of semiconductors, protective films of semiconductor devices, and interlayer dielectric films of high density packaging multilayer interconnections. An electronic device including a surface protective film, an interlayer dielectric film, and the like obtained using the positive-type photosensitive resin composition of the present invention is preferably, for example, a magnetoresistive random access memory (MRAM) having low heat resistance. Namely, the positive-type photosensitive resin composition of the present invention is suitable for use as a surface protective film of MRAM. In addition to MRAM, a polymer memory (polymer ferroelectric RAM (PFRAM)), a phase change memory (phase change RAM (PCRAM)), or ovonics unified memory (OUM), which shows considerable promise as the next generation memory, is most likely to use a novel material having lower heat resistance as compared with a conventional memory. Therefore, the positive-type photosensitive resin composition of the present invention is also suited for use as these surface protective films. It is also possible to use the positive-type photosensitive resin composition in an insulating layer of display devices including a first electrode formed on a substrate and a second electrode provided opposite to the first electrode, for example, LCDs, ECDs, ELDs, and display devices using display organic electroluminescence elements (organic electroluminescent devices). With further miniaturization of structures, copper electrodes and copper wirings are mainly used as electrodes and multilayer wirings of semiconductor devices or wirings of circuit boards in recent years. When a heat-resistant resin coating film formed from the positive-type photosensitive resin composition of the present invention is used as a protective film of the electrodes and wirings, a pattern with high resolution can be formed without causing corrosion of base copper electrodes and copper wirings. Therefore, the heat-resistant resin coating film is used particularly preferably. Because of low curing temperature, stress generated between a sealing resin and a semiconductor chip decreases, and thus sliding of wirings and passivation cracking are less likely to occur, more preferably.

### [Examples]

### Examples 1-7 are not anymore part of the invention.

The present invention will be described below by way of Examples, but the present invention is not limited by these Examples. First, evaluation procedures in the respective Examples and Comparative Examples will be described. A positive-type photosensitive resin composition (hereinafter referred to as a varnish) filtered through a 1 µm thick filter made of polytetrafluoroethylene (manufactured by Sumitomo Electric Industries, Ltd.) in advance was used for evaluation.

### (1) Measurement of Weight Average Molecular Weight

A molecular weight of the component (a) was measured by the following procedure. The measurement was made by a gel permeation chromatography (GPC) system Waters (registered trademark) 2690-996 (manufactured by Nihon Waters K.K.), using N-methyl-2-pyrrolidone (hereinafter referred to as NMP) as a developing solvent. Then, a weight average molecular weight (Mw) was calculated in terms of polystyrene.

### (2) Measurement of Imidation Ratio

An imidation ratio of the component (a) was measured by the following method. First, a powder of the component (a) obtained by the method of each Example was dissolved in γ-butyrolactone (hereinafter referred to as GBL) in the concentration of 35% by weight, and then a coating film was formed on a 6 inch silicon wafer using a coating and developing system Mark-7 (manufactured by Tokyo Electron Limited) so that the thickness of the film after baking at 120°C for 3 minutes became 5 µm. An infrared absorption spectrum of this coating film was measured using FT-720 (manufactured by HORIBA, Ltd.). Next, curing of the wafer formed with the coating film was performed for 5 minutes using a hot plate (Mark-7) at 300°C, and an infrared absorption spectrum of a cured film was measured in the same manner. The imidation ratio was determined by a comparison between peak intensities at about 1,377 cm⁻¹ before and after curing.

### (3) Measurement of Film Thickness

Using an optical interference-type film thickness measurement system LAMBDA ACE STM-602 (manufactured by DAINIPPON SCREEN MFG. CO., LTD.), a film thickness was measured at a refractive index of 1.629.

### (4) Evaluation of Resolution

Using a coating and developing system Mark-7 (manufactured by Tokyo Electron Limited), application of a varnish on a 6 inch silicon wafer and prebaking were performed by a spin coating method so that the thickness of the film after baking at 120°C for 3 minutes became 5 µm. A reticle with a cut-off pattern for evaluation was set in an exposure device i-line stepper DSW-8000 (manufactured by GCA Corporation) and the coating film was exposed at an exposure dose of 500 mJ/cm². After the exposure, using a developing device Mark-7, development with an aqueous 2.38% by weight tetramethylammonium solution (hereinafter referred to as TMAH, manufactured by Tama Chemicals Co., Ltd.) was repeated twice by a paddle method (ejection time of a developing solution of 10 seconds and a paddle time of 40 seconds), followed by rinsing with pure water and further draining and drying to obtain a positive-type coating film pattern. Using an inert oven CLH-21CD-S (manufactured by Koyo Thermo Systems Co., Ltd.), the temperature was raised to 200°C at 3.5°C/minute in the oxygen concentration 20 ppm or less, and a heating treatment was performed at 200°C for one hour. Upon reaching the temperature of 50°C or lower, the wafer was taken out and the pattern was observed by a FDP microscope MX61 (manufactured by OLYMPUS CORPORATION) at a magnification of 20 times. As a result, minimum dimension resolved by line-and-space was regarded as resolution.

### (5) Measurement of Warping Stress

Using a stress measurement system FLX2908 (manufactured by KLA-Tencor Corporation), warping stress of a 6 inch silicon wafer was measured. Using a coating and developing system Mark-7, application of a varnish on a silicon wafer and prebaking were performed by a spin coating method so that the thickness of the film after baking at 120°C for 3 minutes became 10 µm. Using an inert oven CLH-21CD-S (manufactured by Koyo Thermo Systems Co., Ltd.), the temperature was raised to 200°C at 3.5°C/minute in the oxygen concentration 20 ppm or less, and a heating treatment was performed at 200°C for one hour. Upon reaching the temperature of 50°C or lower, the silicon wafer was taken out. After measuring the film thickness of the cured film on the silicon wafer, warping stress of the cured film was measured using the above-mentioned stress measurement system.

### (6) Measurement of Temperature at which 5% Weight Loss Occurs

The cured film on the silicon wafer obtained in (4) was peeled by hydrofluoric acid to obtain a film. An Al cramp cell was packed with 10 mg of the thus obtained single layer film to make a TGA measurement sample. Using TGA-50 (manufactured by Shimadzu Corporation), thermogravimetry was performed while raising the temperature at a rate of 10°C per minute under a nitrogen atmosphere. With respect to the temperature at which a weight loss of 5% from the weight at 200°C occurs, the case where the temperature is lower than 320°C was rated (C) (poor heat resistance), the case where the temperature is 320°C or higher and lower than 350°C was rated (B) (satisfactory heat resistance), and the case where the temperature is 350°C or higher was rated (A) (very satisfactory heat resistance).

### Synthesis Example 1: Synthesis of Quinone Diazide Compound

Under a current of dry nitrogen, 21.22g (0.05mol) of TrisP-PA (trade name, manufactured by Honshu Chemical Industry Co. , Ltd.), 26.86 g (0.10 mol) of 5-naphthoquinonediazidesulfonic acid chloride, and 13.43 g (0.05 mol) of 4-naphthoquinonediazidesulfonic acid chloride were dissolved in 50 g of 1,4-dioxane, followed by returning to room temperature. To the solution, a mixture of 50 g of 1,4-dioxane and 15.18 g of triethylamine was added dropwise so that the temperature in the system does not reach 35°C or higher. After dropwise addition, the mixture was stirred at 30°C for 2 hours. A triethylamine salt was filtered off and the filtrate was poured into water. Thereafter, the precipitate thus formed was collected by filtration. This precipitate was dried by a vacuum dryer to obtain a quinonediazide compound (C) represented by the following formula.

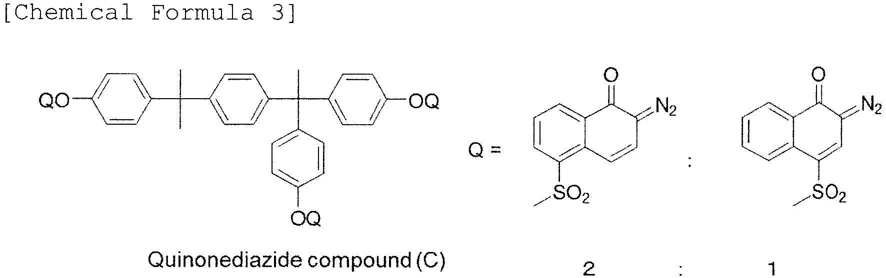

### Example 1

Under a current of dry nitrogen, 29.30 g (0.08 mol) of 2,2-bis(3-amino-4-hydroxyphenyl)hexafluoropropane (hereinafter referred to as BAHF), 1.24 g (0.005 mol) of 1,3-bis(3-aminopropyl)tetramethyldisiloxane, and 3.27 g (0.03 mol) of 4-aminophenol (manufactured by Tokyo Chemical Industry Co., Ltd.) as a terminal blocking agent were dissolved in 80 g of N-methyl-2-pyrrolidone (hereinafter referred to as NMP). To the solution, 31.2 g (0.1 mol) of bis (3,4-dicarboxyphenyl)ether dianhydride (hereinafter referred to as ODPA, manufactured by Manac Incorporated.) was added together with 20 g of NMP, followed by a reaction at 60°C for one hour and further stirring at 180°C for 4 hours. After completion of the stirring, the solution was poured into 3 L of water to obtain a white precipitate. This precipitate was collected by filtration, washed three times with water, and then dried by a vacuum dryer at 80°C for 20 hours to obtain a powder of an alkali-soluble polyimide resin (A-1). As a result of the evaluation by the above method, the resin (A-1) had a weight average molecular weight of 26,000, and an imidation ratio of 92%.

To 10 g of the resin (A-1) thus obtained, 3.0 g of EP-4003S (manufactured by ADEKA CORPORATION) as the component (b), 2.0 g of the quinonediazide compound (C) obtained in Synthesis Example 1 as the component (c), and 10 g of γ-butyrolactone (hereinafter referred to as GBL) as the solvent were added to prepare a varnish, which was evaluated by the above method.

### Example 2

In the same manner as in Example 1, except that 1.0 g of BEO-60E (manufactured by New Japan Chemical Co., Ltd.) was used as the component (b), a varnish was prepared and then evaluated by the above method.

### Example 3

In the same manner as in Example 1, except that BEO-60E (manufactured by New Japan Chemical Co., Ltd.) was used as the component (b), a varnish was prepared and then evaluated by the above method.

### Example 4

In the same manner as in Example 1, except that 5.0 g of EPICLON (registered trademark) EXA-4822 (manufactured by Dainippon Ink and Chemicals, Inc.) was used as the component (b), a varnish was prepared and then evaluated by the above method.

### Example 5

Under a current of dry nitrogen, 22.00 g (0.06 mol) of BAHF, 8.00 g (0.02 mol) of D-400 (manufactured by Huntsman Corporation), 1.24 g (0.005 mol) of 1,3-bis(3-aminopropyl)tetramethyldisiloxane, and 3.27 g (0.03 mol) of 4-aminophenol (manufactured by Tokyo Chemical Industry Co., Ltd.) as the terminal blocking agent were dissolved in 80 g of NMP. To the solution, 31.2 g (0.1 mol) of ODPA was added together with 20 g of NMP, followed by a reaction at 60°C for one hour and further stirring at 180°C for 4 hours. After completion of the stirring, the solution was poured into 3 L of water to obtain a white precipitate. This precipitate was collected by filtration, washed three times with water, and then dried by a vacuum dryer at 80°C for 20 hours to obtain a powder of an alkali-soluble polyimide resin (A-2) . As a result of the evaluation by the above method, the resin (A-2) had a weight average molecular weight of 23,000, and an imidation ratio of 90%.

To 10 g of the resin (A-2) thus obtained, 3.0 g of BEO-60E as the component (b), 2.0 g of the quinonediazide compound (C) obtained in Synthesis Example 1 as the component (c), and 10 g of GBL as the solvent were added to prepare a varnish, which was evaluated by the above method.

### Example 6

In the same manner as in Example 5, except that EPICLON (registered trademark) EXA-4880 (manufactured by Dainippon Ink and Chemicals, Inc.) was used as the component (b), a varnish was prepared and then evaluated by the above method.

### Example 7

In the same manner as in Example 5, except that EPICLON (registered trademark) EXA-4822 (manufactured by Dainippon Ink and Chemicals, Inc.) was used as the component (b), a varnish was prepared and then evaluated by the above method.

### Example 8

Under a current of dry nitrogen, 22.00 g (0.06 mol) of BAHF, 12.00 g (0.02mol) of ED-600 (manufactured by Huntsman Corporation), 1.24 g (0.005 mol) of 1,3-bis(3-aminopropyl)tetramethyldisiloxane, and 3.27 g (0.03 mol) of 4-aminophenol (manufactured by Tokyo Chemical Industry Co., Ltd.) as the terminal blocking agent were dissolved in 80 g of NMP. To the solution, 31.2 g (0.1 mol) of ODPA was added together with 20 g of NMP, followed by a reaction at 60°C for one hour and further stirring at 180°C for 4 hours. After completion of the stirring, the solution was poured into 3 L of water to obtain a white precipitate . This precipitate was collected by filtration, washed three times with water, and then dried by a vacuum dryer at 80°C for20 hours to obtain a powder of an alkali-soluble polyimide resin (A-3) . As a result of the evaluation by the above method, the resin (A-3) had a weight average molecular weight of 26,000, and an imidation ratio of 95%.

To 10 g of the resin (A-3) thus obtained, 3.0 g of EXA-4822 as the component (b), 2.0 g of the quinonediazide compound (C) obtained in Synthesis Example 1 as the component (c), and 10 g of GBL as the solvent were added to prepare a varnish, which was evaluated by the above method.

### Example 9

Under a current of dry nitrogen, 22.00 g (0.06 mol) of BAHF, 18.00 g (0.02 mol) of ED-900 (manufactured by Huntsman Corporation), 1.24 g (0.005 mol) of 1,3-bis(3-aminopropyl)tetramethyldisiloxane, and 3.27 g (0.03 mol) of 4-aminophenol (manufactured by Tokyo Chemical Industry Co., Ltd.) as the terminal blocking agent were dissolved in 80 g of NMP. To the solution, 31.2 g (0.1 mol) of ODPA was added together with 20 g of NMP, followed by a reaction at 60°C for one hour and further stirring at 180°C for 4 hours. After completion of the stirring, the solution was poured into 3 L of water to obtain a white precipitate. This precipitate was collected by filtration, washed three times with water, and then dried by a vacuum dryer at 80°C for 20 hours to obtain a powder of an alkali-soluble polyimide resin (A-4). As a result of the evaluation by the above method, the resin (A-4) had a weight average molecular weight of 25,000, and an imidation ratio of 89%.

To 10 g of the resin (A-4) thus obtained, 3.0 g of EXA-4822 as the component (b), 2.0 g of the quinonediazide compound (C) obtained in Synthesis Example 1 as the component (c), and 10 g of GBL as the solvent were added to prepare a varnish, which was evaluated by the above method.

### Example 10

In the same manner as in Example 8, except that EXA-4880 was used as the component (b) and also 1.0 g of MW-100LM (manufactured by Sanwa Chemical Co. , Ltd.) was used as the component (d), a varnish was prepared and then evaluated by the above method.

### Example 11

In the same manner as in Example 9, except that BEO-60E was used as the component (b) and also 1.0 g of HMOM-TPHAP (manufactured by Honshu Chemical Industry Co., Ltd.) was used as the component (d), a varnish was prepared and then evaluated by the above method.

### Comparative Example 1

In the same manner as in Example 9, except that the component (b) was not used and also 1.0 g of MW-100LM was used as the component (d), a varnish was prepared and then evaluated by the above method.

### Comparative Example 2

In the same manner as in Example 9, except that the component (b) was not used and also 1. 0 g of HMOM-TPHAP was used as the component (d), a varnish was prepared and then evaluated by the above method.

### Comparative Example 3

In the same manner as in Example 9, except that 6.0 g of BEO-60E (manufactured by New Japan Chemical Co., Ltd.) was used as the component (b), a varnish was prepared and then evaluated by the above method.

### Comparative Example 4

In the same manner as in Example 9, except that 6.0 g of EP-4003S was used as the component (b), a varnish was prepared and then evaluated by the above method.

The compositions of the above evaluation varnishes are shown in Table 1.

**[Table 1]**

| Examples 1-7 are not anymore part of the invention. | | | | | | | | |
|---|---|---|---|---|---|---|---|---|
| | Component (a) | | Component (b) | | Component (c) | | Component (d) | |
| | Component | Parts by weight | Component | Parts by weight | Component | Parts by weight | Component | Parts by weight |
| Example 1 | A-1 | 100 | EP-4003S | 30 | (C) | 20 | - | - |
| Example 2 | A-1 | 100 | BEO-60E | 10 | (C) | 20 | - | - |
| Example 3 | A-1 | 100 | BEO-60E | 30 | (C) | 20 | - | - |
| Example 4 | A-1 | 100 | EXA-4822 | 50 | (C) | 20 | - | - |
| Example 5 | A-2 | 100 | BEO-60E | 30 | (C) | 20 | - | - |
| Example 6 | A-2 | 100 | EXA-4880 | 30 | (C) | 20 | - | - |
| Example 7 | A-2 | 100 | EXA-4822 | 30 | (C) | 20 | - | - |
| Example 8 | A-3 | 100 | EXA-4822 | 30 | (C) | 20 | - | - |
| Example 9 | A-4 | 100 | EXA-4822 | 30 | (C) | 20 | - | - |
| Example 10 | A-3 | 100 | EXA-4880 | 30 | (C) | 20 | MW-100LM | 10 |
| Example 11 | A-4 | 100 | BEO-60E | 30 | (C) | 20 | HMOM-TPHAP | 10 |
| Comparative Example 1 | A-4 | 100 | - | - | (C) | 20 | MW-100LM | 10 |
| Comparative Example 2 | A-4 | 100 | - | - | (C) | 20 | HMOM-TPHAP | 10 |
| Comparative Example 3 | A-4 | 100 | BEO-60E | 60 | (C) | 20 | - | - |
| Comparative Example 4 | A-4 | 100 | EP-4003S | 60 | (C) | 20 | - | - |

The above evaluation results are shown in Table 2.

**[Table 2]**

| | Resolution (µm) | Warping stress (MPa) | Temperature at which 5% weight loss occurs |
|---|---|---|---|
| Example 1 | 7 | 33 | B |
| Example 2 | 7 | 36 | A |
| Example 3 | 7 | 33 | A |
| Example 4 | 8 | 25 | A |
| Example 5 | 7 | 27 | A |
| Example 6 | 7 | 25 | A |
| Example 7 | 7 | 25 | A |
| Example 8 | 5 | 20 | A |
| Example 9 | 5 | 18 | A |
| Example 10 | 3 | 15 | A |
| Example 11 | 3 | 13 | A |
| Comparative Example 1 | 5 | 41 | A |
| Comparative Example 2 | 4 | 40 | A |
| Comparative Example 3 | 15 | 10 | A |
| Comparative Example 4 | 15 | 10 | C |

### [Industrial Applicability]

The present invention can provide a positive-type photosensitive resin composition capable of obtaining a high-resolution cured film which exhibits low warpage and also does not cause pattern embedment by reflow during a heating treatment at a low temperature of 200°C or lower.

## Claims

1. A positive-type photosensitive resin composition comprising (a) an alkali-soluble polyimide, (b) a compound having two or more epoxy groups in a molecule, and (c) a photo acid generator, wherein the content of the compound having two or more epoxy groups in a molecule (b) is within a range of 5 to 50 parts by weight based on 100 parts by weight of the alkali-soluble polyimide (a),
wherein the alkali-soluble polyimide (a) includes a diamine residue having a polyalkylene oxide group and/or a carboxylic acid residue having a polyalkylene oxide group.

2. The positive-type photosensitive resin composition according to claim 1, wherein the compound having two or more epoxy groups in a molecule (b) has a polyalkylene oxide group.

3. The positive-type photosensitive resin composition according to claim 1, wherein the proportion of total residues of the diamine residue having a polyalkylene oxide group and the carboxylic acid residue having a polyalkylene oxide group is within a range of 5 to 20 mol% based on 100 mol% of the total of all diamine residues and all carboxylic acid residues included in the alkali-soluble polyimide (a).

4. The positive-type photosensitive resin composition according to claim 2 or 3, wherein the polyalkylene oxide group is a polyethylene oxide group.

5. The positive-type photosensitive resin composition according to any one of claims 1 to 4, further comprising (d) a thermally crosslinkable compound (d), the content of the component (d) being within a range of 1 to 15 parts by weight based on 100 parts by weight of the alkali-soluble polyimide (a).

6. The positive-type photosensitive resin composition according to claim 5, wherein a weight ratio of the compound having two or more epoxy groups in a molecule (b) to the thermally crosslinkable compound (d) is within a range of 15:1 to 1:1.

7. The positive-type photosensitive resin composition according to claim 5 or 6, wherein the thermally crosslinkable compound (d) is a compound having at least two alkoxymethyl groups or methylol groups.

## Patentansprüche

1. Positive lichtempfindliche Harzzusammensetzung, die (a) ein alkalilösliches Polyimid, (b) eine Verbindung mit zwei oder mehr Epoxygruppen in einem Molekül, und (c) einen Photosäurebildner aufweist, wobei der Gehalt der Verbindung mit zwei oder mehr Epoxygruppen in einem Molekül (b) im Bereich von 5 bis 50 Gewichtsteilen liegt, bezogen auf 100 Gewichtsteile des alkalilöslichen Polyimids (a),
wobei das alkalilösliche Polyimid (a) einen Diaminrest mit einer Polyalkylenoxidgruppe und/oder einen Carbonsäurerest mit einer Polyalkylenoxidgruppe einschließt.

2. Positive lichtempfindliche Harzzusammensetzung nach Anspruch 1, wobei die Verbindung mit zwei oder mehr Epoxygruppen in einem Molekül (b) eine Polyalkylenoxidgruppe aufweist.

3. Positive lichtempfindliche Harzzusammensetzung nach Anspruch 1, wobei der Anteil der Gesamtreste des Diaminrests mit einer Polyalkylenoxidgruppe und des Carbonsäurerests mit einer Polyalkylenoxidgruppe im Bereich von 5 bis 20 Mol-% liegt, bezogen auf 100 Mol-% der Gesamtmenge aller Diaminreste und aller Carbonsäurereste, die im alkalilöslichen Polyimid (a) enthalten sind.

4. Positive lichtempfindliche Harzzusammensetzung nach Anspruch 2 oder 3, wobei die Polyalkylenoxidgruppe eine Polyethylenoxidgruppe ist.

5. Positive lichtempfindliche Harzzusammensetzung nach einem der Ansprüche 1 bis 4, die weiterhin (d) eine thermisch vernetzbare Verbindung (d) aufweist, wobei der Gehalt der Komponente (d) im Bereich von 1 bis 15 Gewichtsteilen liegt, bezogen auf 100 Gewichtsteile des alkalilöslichen Polyimids (a).

6. Positive lichtempfindliche Harzzusammensetzung nach Anspruch 5, wobei ein Gewichtsverhältnis der Verbindung mit zwei oder mehr Epoxygruppen in einem Molekül (b) zu der thermisch vernetzbaren Verbindung (d) in einem Bereich von 15:1 bis 1:1 liegt.

7. Positive lichtempfindliche Harzzusammensetzung nach Anspruch 5 oder 6, wobei die thermisch vernetzbare Verbindung (d) eine Verbindung mit mindestens zwei Alkoxymethylgruppen oder Methylolgruppen ist.

## Revendications

1. Composition de résine photosensible de type positif comprenant (a) un polyimide soluble en milieu alcalin, (b) un composé ayant deux groupes époxy ou plus dans une molécule, et (c) un générateur de photoacide, dans la teneur du composé ayant deux groupes époxy ou plus dans une molécule (b) est comprise dans une plage allant de 5 à 50 parties en poids par rapport à 100 parties en poids du polyimide soluble en milieu alcalin (a),
dans laquelle le polyimide soluble en milieu alcalin (a) comporte un résidu de diamine ayant un groupe oxyde de polyalkylène et/ou un résidu d'acide carboxylique ayant un groupe oxyde de polyalkylène.

2. Composition de résine photosensible de type positif selon la revendication 1, dans laquelle le composé ayant deux groupes époxy ou plus dans une molécule (b) a un groupe oxyde de polyalkylène.

3. Composition de résine photosensible de type positif selon la revendication 1, dans laquelle la proportion de résidus totaux du résidu de diamine ayant un groupe oxyde de polyalkylène et du résidu d'acide carboxylique ayant un groupe oxyde de polyalkylène est comprise dans la plage allant de 5 à 20% en mole par rapport à 100% en mole du total de tous les résidus de diamine et de tous les résidus d'acide carboxylique inclus dans le polyimide soluble en milieu alcalin (a).

4. Composition de résine photosensible de type positif selon la revendication 2 ou 3, dans laquelle le groupe oxyde de polyalkylène est un groupe oxyde de polyéthylène.

5. Composition de résine photosensible de type positif selon l'une quelconque des revendications 1 à 4, comprenant en outre (d) un composé thermiquement réticulable (d), la teneur du composant (d) étant comprise dans une plage allant de 1 à 15 partie(s) en poids par rapport à 100 parties en poids du polyimide soluble en milieu alcalin (a).

6. Composition de résine photosensible de type positif selon la revendication 5, dans laquelle le rapport pondéral du composé ayant deux groupes époxy ou plus dans une molécule (b) sur le composé thermiquement réticulable (d) est compris dans une plage allant de 15:1 à 1:1.

7. Composition de résine photosensible de type positif selon la revendication 5 ou 6, dans laquelle le composé thermiquement réticulable (d) est un composé ayant au moins deux groupes alcoxyméthyle ou des groupes méthylol.
